# EUROPEAN PATENT SPECIFICATION

(11) **EP 0 522 580 B1**
(45) Date of publication and mention of the grant of the patent: **07.01.1998**
(21) Application number: 92111772.7
(22) Date of filing: 10.07.1992
(51) Int. Cl.: H03K 19/14

(54) **Method and circuit for controlling the operation of an imaging system**
Verfahren und Vorrichtung zur Steuerung des Betriebs eines Bilderzeugungssystems
Méthode et dispositif de commande du fonctionnement d'un système d'imagerie

(30) Priority: 12.07.1991 US 728925
(43) Date of publication of application: 13.01.1993
(73) Proprietor: TEXAS INSTRUMENTS INCORPORATED, Dallas Texas 75265 (US)
(72) Inventor: Sampsell, Jeffrey B., Plano, Texas 75075 (US)
(74) Representative: Schwepfinger, Karl-Heinz, Dipl.-Ing.

(56) References cited:
- EP-A- 0 329 083
- WO-A-86/07494
- US-A- 4 960 988
- IBM TECHNICAL DISCLOSURE BULLETIN vol. 31, no. 9, 1 February 1989, ARMONK,US pages 218 - 221 'Opto-Electronic Signal Processing Element'

## Description

### 1. Field of the Invention

This invention relates to imaging systems and the like, more specifically, to a method and a circuit for controlling the operation of an imaging system.

### 2. Background of the Invention

It is desirable to be able to control at what levels of light optical systems operate for many reasons. Two of these reasons are, for example, to prevent pirating of devices, and to save wear and tear on the system.

A manufacturer may produce optical systems having three different markets which depend on the size of the system. In displays, for example, three possible markets include commercial projection systems, large screen televisions (greater that thirty inches) and small screen televisions. The same devices, namely optical memories, spatial light modulators or other light sensitive devices could be used in each. It would be possible to acquire a smaller, less expensive television and make a large screen television, or a projection system using only certain parts that would usually be used in the larger systems.

The common element in the systems is the use of light, and each level of system requires a different level of light. For example, the large projection system may require high levels of illumination and the television a much lower level. It would therefore be beneficial to limit the devices in each system to a certain "window of illumination" at which only the relevant system can operate.

Another important reason to control the operation would be to prevent damage to parts of a system. For example, if a system works efficiently at a certain level of illumination, the system may be susceptible to wear if it operates at an inefficient level.
In addition, individual devices may be damaged by relatively high levels of illumination. If too much light were to impinge upon a device, the device should ideally be able to be shut down to prevent damage.
US-A-4 960 988 discloses a safety shut-off protection system for a light responsive system, such as an image intensifier. The system includes several series-connected, normally-closed, light responsive photoelectric Darlington safety switches which are located to receive light along with the light responsive system. Light exceeding a threshold intensity impinging on any one of the Darlington safety switches causes such a switch to operate to deactivate the light sensitive system.

### SUMMARY OF THE INVENTION

According to one aspect of the present invention, there is provided a method for controlling the operation of an imaging system as defined in Claim 1.

According to another aspect of the present invention, there is provided a circuit for controlling the operation of an imaging system as defined in Claim 8.

### BRIEF DESCRIPTION OF THE DRAWINGS

For a more complete understanding of the present invention, and the advantages thereof, reference is now made by way of example to the following descriptions taken in conjunction with the accompanying drawings, in which:

FIGURE 1 shows a structure for allowing light into a substrate.

FIGURE 2 shows a device for controlling operation of a signal.

FIGURE 3a shows an alternate device for controlling operation of a signal.

FIGURE 3b shows a logic table for the device shown in Figure 3a.

### DETAILED DESCRIPTION OF THE PREFERRED EMBODIMENTS

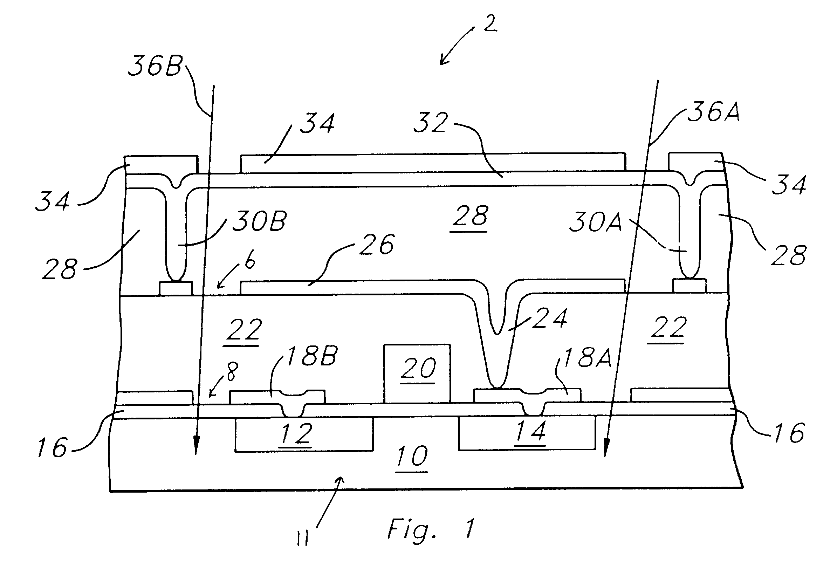

Figure 1 shows one example of way to control operation of an optical system. When a device is shown generally at 2 manufactured, gaps 4, 6 and 8 can be left in the top layer and subsequent lower layers to allow passage of light into the substrate. The device is for example, a deformable mirror device (DMD), but it is understood that the method could be used in any photo-sensitive device.

In one embodiment, the device has transistors in the substrate 10, one of which 11 is shown. Drain 12 and source 14 are formed in the substrate. A layer of gate oxide 16 is then laid upon them. Gate 20 is formed, normally out of polysilicon. Contact metal 18a and 18b is formed over the gate oxide. If planarization is desired, layer 22 can be deposited and etched to form a flat layer. Via 24 is etched into the planarization layer 22, which is normally some kind of glass such as BPSG. A metal layer is then deposited and etched. The metal fills via 24. The metal is then patterned and etched to form electrodes, one of which 26 is shown.

To form the mirror elements in DMDs a layer 28 is deposited over the electrode 26 and is used as a spacer. Vias 30a and 30b are then patterned into the spacer for receiving posts, for example. A layer of hinge metal 32 is deposited over the spacer, thereby filling the vias and forming the support posts and hinges. Metal layer 34 is then deposited and etched except where mirror elements are desired. The spacer is then etched out from underneath the mirror to leave a gap. The resultant device consists of a wide mirror element supported by thin hinges over an air gap, at the bottom of which lies an electrode.

If this device is carefully aligned during the manufacture, light paths 36a and 36b will be left in the device. Light can then enter the substrate by passing around the thin hinges through the air gap and the planarization layer into the substrate. When light comes in contact with the substrate, it causes the generation of photocarriers, which in turn cause high leakage current in the transistor, and the device shuts off. The sensitivity of the device to too much light can thus be used to shut off at higher levels of illumination.

Problems with this approach exist. One possible problem is that the device must be manufactured with a certain optical path alignment. It would be possible to remove the device and use it in a different optical path geometry, thereby avoiding the shut off effect. Additionally, this method only limits the use of the device a high levels of illumination.

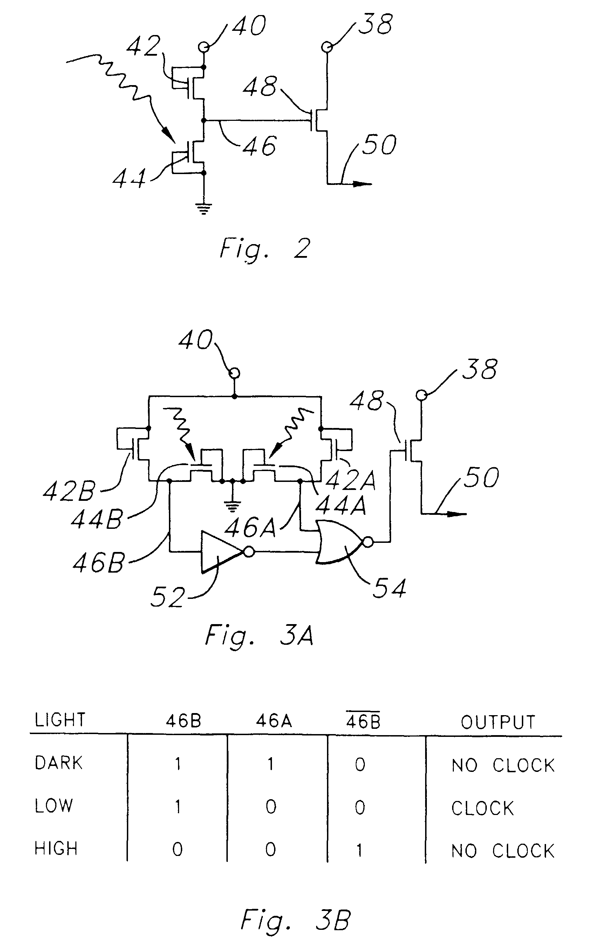

An alternative approach is shown in Figure 2. A circuit for controlling the device which may be located to one side of the device is shown. A system clock 38 is assumed to be the clock driving the device, but it is possible to replace this with any signal essential to operation of the system or device. A voltage supply 40 is connected through a load transistor 42 to a phototransistor 44. When the system is operating at a lower level of illumination, phototransistor 44 is off, and line 46 out of transistor 42 is high. With line 46 high, transistor 48 is fed by line 46, transistor 48 is on and the clock signal from clock 38 can pass to the system through line 50. When an excessive level of illumination occurs, phototransistor 44 turns on, pulling line 46 low. When line 46 is low, transistor 48 is off, and the clock signal 38 does not pass to line 50. The device therefore does not have a clock, and is shut off. This approach has the advantage of being optical system independent, but again does not allow control at any level other than excessive levels of illumination. It is also possible to bypass this technique. As the phototransistor is off when it is not illuminated and it is this part of the device through which light enters it is possible that the window be covered with something that would prevent illumination.

Another approach is shown in Figure 3a. In this system two phototransistors 44a and 44b are used. Any other light sensitive elements that can affect the signal line passing to the logic gate can be used instead of phototransistors, for example photodiodes. One transistor, 44a, becomes active at low levels of light, this is referred to as the "weak" transistor. The other transistor, 44b becomes active at higher levels of light, this is referred to as the "strong" transistor. Both transistors are powered by voltage supply 40 through load transistors 42a and 42b. When the system is no illuminated, both transistors are off. The output line 46a from the weak transistor is fed directly into a logic device, in this embodiment an NOR gate 54. The output line 46b from the strong transistor is inverted at 52 before being fed into the NOR gate 54. The output of the gate is then connected to the clock line 38 through transistor 48.

As can be seen in the logic table of Figure 3b, when the system is not illuminated, both transistors are off. Lines 46a and 46b are high. But as line 46b is inverted, so the two inputs to the NOR gate are high and low respectively. The line between the NOR gate and the transistor 48 is then low and the clock signal does not pass, thus the device will not operate.

At low levels of illumination, the "weak" transistor will come on. This pulls line 46a low. Line 46b is unaffected since the light is not sufficiently strong to turn on transistor 44b. The input to the NOR gate are therefore low which two results in a high signal to transistor 48. This will allow the clock signal to pass onto line 50 and out to the system.

At high levels of illumination, both transistor come on and both lines 46a and 46b go low. This results in high and low inputs into the NOR gate 54, which results in a low output signal. This cause transistor 48 to stay off and the clock signal does not get to the system.

Because transistor 48 will only operate when its input line is high, if the input line were burned through by laser, the control signal would never pass through the transistor to the system. Instead of a single transistor, a logic gate such as an AND gate could be used and would overcome any problems that may exist as a result of a floating line from the cut This would require that the line from the circuit and the clock signal to be high so the clock will pass to the system. It will be appreciated that this system relates to optically visible radiation, but may be adapted for use in any appropriate frequency range including, for example, IR, UV, etc and that the term optical should be construed accordingly.

Thus, although there has been described to this point a particular embodiment for a method to control operation of optical systems, it is not intended that such specific references be considered as limitations upon the scope of this invention except in-so-far as set forth in the following claims.

## Claims

1. A method of controlling the operation of an imaging system by making use of:
at least two light sensitive devices (44a,44b) providing output signals (46a,46b), wherein at least one of said light sensitive devices is more sensitive to light than other of said devices;
a logic device (52,54) providing an output signal and receiving as input signals said output signals (46a,46b) of each of said at least two light sensitive devices (44a,44b); and
a logic gate (48) having a first input receiving the output signal of said logic device (52,54), a second input receiving an operating signal (38) for operating said imaging system, and having an output connected to said imaging system,
wherein the logic gate (48) selectively releases said operating signal (38) for operating said imaging system dependent upon the presence of said output signal of said logic device (52,54), and wherein said output signal of said logic device (52,54) is provided only in response to the presence of light incident upon the light sensitive devices (44a,44b) having an intensity which is above a first threshold intensity value and below a second, higher threshold intensity value, wherein the first and second threshold values are determined by the selected light sensitive devices (44a,44b).

2. The method of Claim 1 wherein said logic device (52,54) includes an inverter inverting at least one of said at least two radiation sensitive device output signals.

3. The method of Claim 1 or Claim 2, wherein said logic gate is a transistor having a gate for receiving said output signal of said logic device, whereby, when said output signal causes said transistor to turn on, said operating signal (38) is passed through by said transistor to said imaging system, which then is allowed to operate.

4. The method of any preceding claim, wherein said radiation sensitive devices are phototransistors.

5. The method of any of claims 1 to 3 wherein said radiation sensitive devices are photodiodes.

6. The method of any preceding claim, wherein said logic device includes a NOR gate (54).

7. The method of any preceding claim, wherein said logic device includes an inverter (52).

8. A circuit for controlling the operation of an imaging system, comprising:
at least two light sensitive devices (44a,44b), at least one of said light sensitive devices being more sensitive to light than other of said devices;
a logic device (52,54) having an output and having inputs connected to each of said outputs of said light sensitive devices;
a logic gate (48) having a first input connected to the output of said logic device (52,54), a second input for receiving an operating signal (38) for operating said imaging system, and having an output for being connected to said imaging system,
wherein the logic gate (48) is suitable for selectively releasing said operating signal (38) for operating said imaging system dependent upon the presence of an output signal at the output of said logic device (52,54), and wherein said logic device (52,54) is suitable for providing said output signal only in response to the presence of light incident upon the light sensitive devices (44a,44b) having an intensity which is above a first threshold intensity value and below a second, higher threshold intensity value, wherein the first and second threshold values are determined by the selected light sensitive devices (44a,44b).

## Patentansprüche

1. Verfahren zum Steuern des Betriebs eines Abbildungssystems unter Verwendung:
wenigstens zweier lichtempfindlicher Vorrichtungen (44a, 44b) für die Erzeugung von Ausgangssignalen (46a, 46b), wobei wenigstens eine der lichtempfindlichen Vorrichtungen lichtempfindlicher als die andere der Vorrichtungen ist;
einer Logikvorrichtung (52, 54), die ein Ausgangssignal erzeugt und als Eingangssignale die Ausgangssignale (46a, 46b) jeder der wenigstens zwei lichtempfindlichen Vorrichtungen (44a, 44b) empfängt; und
einem Logikgatter (48) mit einem ersten Eingang, der das Ausgangssignal der Logikvorrichtung (52, 54) empfängt, einem zweiten Eingang, der ein Betriebssignal (38) zum Betreiben des Abbildungssystems empfängt, und einem Ausgang, der an das Abbildungssystem angeschlossen ist,
wobei das Logikgatter (48) das Betriebssignal (38) zum Betreiben des Abbildungssystems wahlweise in Abhängigkeit vom Vorliegen des Ausgangssignals der Logikvorrichtung (52, 54) freigibt und wobei das Ausgangssignal der Logikvorrichtung (52, 54) nur erzeugt wird als Antwort auf das Vorhandensein von auf die lichtempfindlichen Vorrichtungen (44a, 44b) auftreffendem Licht, dessen Intensität höher als ein erster Schwellenintensitätswert und niedriger als ein zweiter, höherer Schwellenintensitätswert ist, wobei der erste und der zweite Schwellenwert durch die ausgewählten lichtempfindlichen Vorrichtungen (44a, 44b) bestimmt sind.

2. Verfahren nach Anspruch 1, bei dem die Logikvorrichtung (52, 54) einen Inverter enthält, der wenigstens eines der wenigstens zwei Ausgangssignale der strahlungsempfindlichen Vorrichtungen invertiert.

3. Verfahren nach Anspruch 1 oder Anspruch 2, bei dem das Logikgatter ein Transistor ist, dessen Gate das Ausgangssignal der Logikvorrichtung empfängt, wobei dann, wenn das Ausgangssignal den Transistor auf Durchlaß schaltet, das Betriebssignal (38) vom Transistor zum Abbildungssystem durchgelassen wird, dessen Betrieb dann zugelassen wird.

4. Verfahren nach irgendeinem vorangehenden Anspruch, bei dem die strahlungsempfindlichen Vorrichtungen Phototransistoren sind.

5. Verfahren nach irgendeinem der Ansprüche 1 bis 3, bei dem die strahlungsempfindlichen Vorrichtungen Photodioden sind.

6. Verfahren nach irgendeinem vorangehenden Anspruch, bei dem die Logikvorrichtung ein NOR-Gatter (54) enthält.

7. Verfahren nach irgendeinem vorangehenden Anspruch, bei dem die Logikvorrichtung einen Inverter (52) enthält.

8. Schaltung zum Steuern des Betriebs eines Abbildungssystems, mit:
wenigstens zwei lichtempfindlichen Vorrichtungen (44a, 44b), wovon wenigstens eine lichtempfindlicher als andere der Vorrichtungen ist;
einer Logikvorrichtung (52, 54) mit einem Ausgang und mit Eingängen, die an jeden der Ausgänge der lichtempfindlichen Vorrichtungen angeschlossen sind;
einem Logikgatter (48) mit einem ersten Eingang, der an den Ausgang der Logikvorrichtung (52, 54) angeschlossen ist,
einem zweiten Eingang zum Empfangen eines Betriebssignals (38) zum Betreiben des Abbildungssystems und einem Ausgang, der an das Abbildungssystem angeschlossen ist,
wobei das Logikgatter (48) das Betriebssignal (38) zum Betreiben des Abbildungssystems in Abhängigkeit vom Vorhandensein eines Ausgangssignals am Ausgang der Logikvorrichtung (52, 54) wahlweise freigeben kann und wobei die Logikvorrichtung (52, 54) ein Ausgangssignal nur erzeugen kann als Antwort auf das Vorhandensein von auf die lichtempfindlichen Vorrichtungen (44a, 44b) auftreffendem Licht mit einer Intensität oberhalb eines ersten Schwellenintensitätswerts und unterhalb eines zweiten, höheren Schwellenintensitätswerts, wobei der erste und der zweite Schwellenwert durch die ausgewählten lichtempfindlichen Vorrichtungen (44a, 44b) bestimmt sind.

## Revendications

1. Procédé pour commander le fonctionnement d'un système de formation d'images, selon lequel on utilise :
au moins deux dispositifs photosensibles (44a, 44b) délivrant des signaux de sortie (46a, 46b), au moins l'un desdits dispositifs photosensibles étant plus sensible à la lumière que l'autre desdits dispositifs ;
un dispositif logique (52, 54) délivrant un signal de sortie et recevant, comme signaux d'entrée, lesdits signaux de sortie (46a, 46b) de chacun desdits au moins deux dispositifs photosensibles (44a, 44b) ; et
une porte logique (48) possédant une première entrée recevant le signal de sortie dudit dispositif logique (52, 54), une seconde entrée recevant un signal de fonctionnement (38) pour faire fonctionner le système de formation d'images et comportant une sortie connectée audit système de formation d'images,
selon lequel la porte logique (48) libère sélectivement ledit signal de fonctionnement (38) pour faire fonctionner ledit système de formation d'images en fonction de la présence dudit signal de sortie dudit dispositif logique (52, 54), et selon lequel ledit signal de sortie dudit dispositif logique (52, 54) est délivré uniquement en réponse à la présence d'une lumière rencontrant les dispositifs photosensibles (44a, 44b) et possédant une intensité qui est supérieure à une première valeur d'intensité de seuil et inférieure à une seconde valeur d'intensité de seuil plus élevée, les première et seconde valeurs de seuil étant déterminées par les dispositifs photosensibles sélectionnés (44a, 44b).

2. Procédé selon la revendication 1, selon lequel ledit dispositif logique (52, 54) comprend un inverseur qui inverse au moins l'un desdits au moins deux signaux de sortie du dispositif sensible au rayonnement.

3. Procédé selon la revendication 1 ou la revendication 2, selon lequel ladite porte logique est un transistor comportant une grille servant à recevoir ledit signal de sortie dudit dispositif logique, ce qui a pour effet que, lorsque ledit signal de sortie fait passer ledit transistor à l'état conducteur, ledit signal de fonctionnement (38) est transmis par ledit transistor audit système de formation d'images, qui est alors autorisé à fonctionner.

4. Procédé selon l'une quelconque des revendications précédentes, selon lequel lesdits dispositifs sensibles au rayonnement sont des phototransistors.

5. Procédé selon l'une quelconque des revendications 1 à 3, selon lequel lesdits dispositifs sensibles au rayonnement sont des photodiodes.

6. Procédé selon l'une quelconque des revendications précédentes, selon lequel ledit dispositif logique comporte une porte NON-OU (54).

7. Procédé selon l'une quelconque des revendications précédentes, selon lequel ledit dispositif logique inclut un inverseur (52).

8. Circuit pour commander le fonctionnement d'un système de formation d'images comprenant :
au moins deux dispositifs photosensibles (44a, 44b) délivrant des signaux de sortie, au moins l'un desdits dispositifs photosensibles étant plus sensible à la lumière que l'autre desdits dispositifs ;
un dispositif logique (52, 54) possédant une sortie et possédant des entrées connectées à chacun desdites sorties desdits dispositifs photosensibles ; et
une porte logique (48) possédant une première entrée connectée à la sortie dudit dispositif logique (52, 54), une seconde entrée servant à recevoir un signal de fonctionnement (38) pour faire fonctionner le système de formation d'images et comportant une sortie destinée à être connectée audit système de formation d'images,
selon lequel la porte logique (48) est adaptée pour libérer sélectivement ledit signal de fonctionnement (38) pour faire fonctionner ledit système de formation d'images en fonction de la présence d'un signal de sortie à la sortie dudit dispositif logique (52, 54), et dans lequel ledit dispositif logique (52, 54) est adapté pour délivrer ledit signal de sortie uniquement en réponse à la présence d'une lumière rencontrant les dispositifs photosensibles (44a, 44b) et possédant une intensité qui est supérieure à une première valeur d'intensité de seuil et inférieure à une seconde valeur d'intensité de seuil plus élevée, les première et seconde valeurs de seuil étant déterminées par les dispositifs photosensibles sélectionnés (44a, 44b).
